# EUROPÄISCHE PATENTANMELDUNG

(11) **EP 3 564 702 A1**
(43) Veröffentlichungstag der Anmeldung: **06.11.2019**
(21) Anmeldenummer: 18170172.3
(22) Anmeldetag: 30.04.2018
(51) Int. Cl.: G01S 7/487, G01S 7/486

(54) **VERFAHREN ZUR VERBESSERUNG DER LAUFZEIT- UND/ODER PHASENMESSUNG**

(71) Anmelder: Lambda: 4 Entwicklungen GmbH, 22767 Hamburg (DE)
(72) Erfinder: Reimann, Rönne, 22769 Hamburg (DE)
(74) Vertreter: Raffay & Fleck

(57) **Zusammenfassung**

Die Erfindung betrifft ein Verfahren zur Verbesserung der Laufzeit- und/oder Phasenmessung und/oder zur Synchronisierung in digitalen Übertragungssystemen.

Erfindungsgemäß wird mittels des Übertragungssystems mindestens eine erste, insbesondere digitale, Information in mindestens einem ersten analogen Signal codiert zwischen zwei Objekten übertragen und wird mindestens ein erster Abtastwert des mindestens einen ersten analogen Signals verwendet, um eine zeitlichen Lage und/oder Phasenlage zu bestimmen. Dabei liegt der mindestens eine erste Abtastwert in einer steigenden oder fallenden Flanke des mindestens einen ersten analogen Signals und/oder des mindestens einen ersten empfangenen analogen Signals, was beispielsweise aus dem Abtastwert selbst und/oder dem Verlauf benachbarter Abtastwerte erkannt werden kann.

## Beschreibung

Verfahren zur Verbesserung der Laufzeit- und/oder Phasenmessung und/oder zur Synchronisierung in digitalen Übertragungssystemen.

Es ist bekannt, zur Entfernungsmessung eine Laufzeitmessung des Signals zu verwenden. Dazu wird in die Regel die Phasenverschiebung oder Flugzeit eines Signals gemessen.

In digitalen Systemen, die zur Datenübertragung genutzt werden, werden die digitalen Daten durch bestimmte Verfahren in meist elektromagnetische Signale zur Übertragung umgewandelt und beim Empfänger wieder decodiert. Dazu werden verschiedene Codier- und/oder Modulationsverfahren, teilweise mit Signalformungsverfahren eingesetzt. In der Regel werden die Daten auf ein niederfrequentes analoges Signal aufmoduliert und wird dieses Signal dann mit einer höheren Frequenz gemischt. Beim Empfänger werden dann die digitalen Daten wieder aus dem hochfrequenten Signal extrahiert. Dazu wird in der Regel mittels Mischer zunächst auf eine niedrige oder mittlere Frequenz transformiert, um anschließend die Daten zu extrahieren. Genutzt werden dazu beispielsweise Verfahren wie PSK (Phasenumtastung), FSK (Frequenzumtastung) auch in der Form GFSK (Gaußsche Frequenzumtastung) und/oder I&Q (In-Phase-&-Quadrature-Verfahren) oder QAM (Quadraturamplitudenmodulation).

Aber auch bei Übertragungen über Kabel oder Lichtleiter kommen oben genannte oder ähnliche Verfahren zur Codierung der Information teilweise zum Einsatz.

Am Empfänger wird ein Analog-Digital-Wandler verwendet, mit Hilfe dessen die digitalen Signale zurück gewonnen werden. Dabei werden üblicherweise die zunächst mit dem Analog-Digital-Wandler gewonnen Informationen über den tatsächlichen analogen Signalverlauf größtenteils verworfen und allein die digitale Information weiterverarbeitet, die mit größter Wahrscheinlichkeit in dem analogen Signal codiert war. Dazu sind zahlreiche Techniken bekannt, die Wahrscheinlichkeiten zu beeinflussen bzw. zu verschieben, und die Übertragungssicherheit und/oder Menge der Daten pro Zeit und/oder pro Bandbreite zu optimieren.

Dies ist jedoch nicht Gegenstand der Erfindung. Vielmehr ist es ihre Aufgabe, durch gezielte Nutzung des analogen Signals oder die zunächst mit dem Analog-Digital-Wandler gewonnen Informationen über das analoge Signal, das beispielsweise über ein Kabel, einen Lichtleiter und/oder per Funk übertragen wurde, die zeitliche Lage des Signal und/oder die Phasenlage des Signals zu ermitteln und/oder Zeiten zu synchronisieren und zwar mit höherer Genauigkeit, als dies in bestehenden System, insbesondere zur Übertragung digitaler Daten, möglich ist, insbesondere ohne die Anforderungen an die Hardware weiter zu erhöhen. Mit besonderem Vorteil geschieht dies mittels eines analogen Signals, in dem digitale Informationen codiert sind, insbesondere einem vorbekannten.

Um eine zuverlässige Decodierung eines digitalen Datenstroms in einem analogen Signal zu gewährleisten muss das Sampling im Analog-Digital-Wandler mit einer Frequenz erfolgen, die deutlich höher liegt als die für die Datenübertragung notwendige Bandbreite der Frequenz des analogen Signals und/oder der Bandbreite der Frequenz des Signals, das, ggf. nach Filterung, dem Sampling im Analog-Digital-Wandler zugeführt wird. Dazu weisen Analog-Digital-Wandler meist vorgeschaltete, teilweise integrierte Filter auf. Dabei muss in der Regel die Abtast- oder Samplingrate oder -frequenz um mindestens etwa den Faktor zwei höher liegen als die für die Datenübertragung notwendige Bandbreite der Frequenz des analogen Signals und/oder der Bandbreite der Frequenz des Signals, das, ggf. nach Filterung, dem Sampling im Analog-Digital-Wandler zugeführt wird (Nyquist-Shannon-Abtasttheorem). Die Abtast- oder Samplingrate oder -frequenz liegt in der Regel auch mindestens beim doppelten der Chip- oder Symbolrate. Beispielsweise ist im Bluetooth Band bei 2450MHz mit einer durch Filterung (GFSK etc.) erreichten maximalen Ausgangsbandbreite am Sender von 2 MHz zu rechnen. Am Empfänger erfolgt in der Regel ein Sampling mit einer Abtastfrequenz von mindestens um 4 MHz.

Auf direktem Wege kann dann der Zeitpunkt einer Veränderung des empfangenen Signals (beispielsweise Veränderung von Amplitude und/oder Phase; insbesondere auf Grund einer Änderung des abgestrahlten Signals) nur mit einer maximalen Auflösung von 4 MHz erfasst werden.

In der Praxis wird aber intern in den verwendeten Chips bereits mit höheren Sampling raten gearbeitet, um eine möglichst robuste Übertragung zu gewährleisten.

Bei Bluetooth beispielsweise ist die Symbolrate 1MHz, die Sendefrequenz für logisch "1" liegt 500kHz oberhalb der Mittenfrequenz, für "0" liegt 500kHz unterhalb der Mittenfrequenz. Typischerweise wird mit der Mittenfrequenz gemischt, also bei logisch "1" mit Zwischenfrequenz plus 500KHz und bei logisch "0" mit Zwischenfrequenz minus 500kHz gearbeitet. Die Phase dreht dabei für eine logische "1" um XX° nach vorne und für logisch "0" XX° rückwärts.

Beim Senden wird die Frequenz aber in der Regel nicht stufenartig verstellt, da dies zu einer hohe Bandbreite oder Störungen in den Nebenkanälen führen würde, sondern meist mittels GFSK ein möglichst kontinuierlicher Übergang durchgeführt. Vorteilhafterweise wird zusätzlich der Signalverlauf meist im Empfänger hinter dem Mischer durch Filter vor der A/D Abtastung geglättet. Insbesondere einen solchen Signalverlauf macht sich die Erfindung zu nutze.

Ist der Verlauf des übertragenen, empfangenen oder abgestrahlten analogen Signals zumindest näherungsweise zumindest abschnittsweise bekannt, kann durch Auswertung dieses analogen Signalverlaufs, insbesondere einer Flanke des Signals, beispielsweise des Anstiegs der Amplitude, unter Ausnutzung der ohnehin erforderlichen und/oder verwendeten Samplingrate eine deutlich höhere Genauigkeit der Analyse der zeitlichen Lage des Signal oder der Flanke, der Phasenlage und/oder der Laufzeitmessung erreicht werden und dadurch auch eine deutlich genauere Synchronisierung, beispielsweise Zeitsynchronisierung, zwischen Sender und Empfänger und eine genauere Messung der Signallaufzeit erreicht werden und zwar um üblicherweise ohne Änderung der Hardware einen Faktor zwischen 2 und 16 genauer, was von der verwendeten Hardware abhängt, insbesondere vom Verhältnis der Bandbreite zur Samplingrate und der Auflösung (Bitttiefe) des Samplings.

Gelöst wird die Aufgabe insbesondere durch ein Verfahren zur Analyse der zeitlichen Lage und/oder Phasenlage, insbesondere zur Laufzeitmessung, Phasenmessung oder Synchronisierung, in einem, insbesondere digitalen, Übertragungssystem.

Dabei lassen sich die zeitliche Lage und Phasenlage meist ineinander konvertieren oder in eine feste Beziehung setzten und sind aus der zeitlichen Lage oder Phasenlage in der Regel Laufzeitmessungen, Messungen der Phasenverschiebung oder eine Synchronisation möglich.

Dabei werden die zeitliche Lage und/oder Phasenlage insbesondere gegen eine Referenzzeit und/oder einen Referenztakt gemessen.

Erfindungsgemäß wird mittels des Übertragungssystems mindestens eine erste, insbesondere digitale, Information in mindestens einem ersten analogen Signal codiert von einem ersten zu einem zweiten Objekt und/oder zwischen zwei Objekten, insbesondere mittels mindestens eines ersten elektrischen, magnetischen oder elektromagnetischen Signals, insbesondere Welle, übertragen. Vorteilhafterweise wird insbesondere an und/oder in einem ersten der zwei Objekte zum Senden des mindestens einen ersten analogen Signals die mindestens eine erste Information in das mindestens eine erste analoge Signal mit einer ersten Frequenzbandbreite gewandelt, insbesondere mittels eines Modulation- und/oder Codierverfahren, wie QAM, FSK, insbesondere GFSK, und insbesondere mittels des mindestens einen ersten magnetischen, elektrischen oder elektromagnetischen Signals gesendet. Dabei kann das erste analoge Signale vor dem Senden weiter bearbeitet, insbesondere mit einer Trägerfrequenz gemischt und/oder gefiltert, werden. Das mindestens eine erste analoge Signal kann das mindestens eine erste magnetische, elektrische oder elektromagnetische Signal darstellen. Es ist zum Beispiel aber auch denkbar, dass das mindestens eine erste magnetische, elektrische oder elektromagnetische Signal durch Mischen des ersten analogen Signals mit einer Trägerfrequenz erzeugt wird.

Das mindestens eine erste Signal wird insbesondere vom ersten der zwei Objekte abgestrahlt.

Der Verlauf des Signals kann in der Regel aus Kenntnis der Parameter und Eigenschaften der Hardware des Senders oder Senders und Empfängers und der Kenntnis der übertragenden Information gewonnen werden und/oder gemessen und oder basierend auf Messungen berechnet werden. Je nach Ausgestaltung des Systems kann die Information des Signalverlaufs und/oder die zur Bestimmung dessen notwendigen Angaben über das gleiche Medium wie das Signal übertragen werden.

Als Signal kann dabei z.B. das Signal, das zur digitalen Datenübertragung verwendet wird, verwendet werden, aber auch ein anderes, das beispielsweise ausschließlich zu diesem Zweck verwendet wird und/oder z.B. die wiederholte und/oder andauernde Übertragung eines vorbestimmten und/oder konstanten logischen Signals, beispielsweise einer 0 oder einer 1, und/oder die wiederholte und/oder andauernde Übertragung des reinen Trägersignals, insbesondere für eine Zeitdauer zwischen 0,1 und 100ms, insbesondere für mindestens 2ms und/oder maximal 50ms, und/oder 10 bis 10000 Wiederholungen verwendet werden.

Angewendet werden kann dieses Verfahren in zahlreichen bekannten Übertragungssystemen wie Bluetooth, Wifi, DECT, Mobilfunk (GSM, UMTS, LTE, 5G), Ethernet und anderen. In vielen derartigen System ist die aktuell verbaute Hardware bereits in der Lage, die Erfindung umzusetzen. Mit Vorteil ist das erfindungsgemäße System somit ein Bluetooth, Wifi, DECT, Mobilfunk (GSM, UMTS, LTE, 5G) und/oder Ethernetsystem. Somit ist eine einfache und kostengünstige Implementation auch in bestehenden System meist möglich, meist durch Software und/oder Firmwareupdate.

Ist zudem der Signalverlauf oder Verlauf der Flanke einem potenziellen Angreifer nicht bekannt, lässt sich dadurch eine Zuverlässige Sicherung gegen Relaisangriffe erreichen, beispielsweise in Zugangskontrollsystemen, wie einem Auto mit Funkschlüssel.

Vorteilhafterweise wird und nach dem Empfang des mindestens einen ersten elektrischen, magnetischen oder elektromagnetischen Signals und/oder ersten analogen Signals an und/oder in einem zweiten der zwei Objekte eine Umwandlung des mindestens einen ersten elektrischen, magnetischen oder elektromagnetischen Signals und/oder ersten analogen Signals in empfangene erste, insbesondere digitale, Information durchgeführt, die insbesondere möglichst der ersten digitalen Information entspricht und/oder wobei die Umwandlung insbesondere so erfolgt, dass die erste Information mit möglichst großer Wahrscheinlichkeit, mit großer Wahrscheinlichkeit und/oder bei Ausbleiben von Störungen wieder erhalten wird. Dies erfolgt insbesondere mittels mindestens eines ersten Analog-Digital-Wandlers, insbesondere an und/oder im zweiten Objekt, wobei mit dem mindestens einen ersten Analog-Digital-Wandler insbesondere eine Abtastung und/oder ein Sampling, insbesondere des mindestens einen ersten elektrischen, magnetischen oder elektromagnetischen Signals und/oder ersten analogen Signals, mit einer ersten Abtast- und/oder Samplingrate durchgeführt wird, wobei die erste Abtast- und/oder Samplingrate mindestens doppelt so groß und/oder schnell ist wie die erste Frequenzbandbreite, wie die Frequenzbandbreite des dem Analog-Digital-Wandler zugeführten Signals und/oder wie die Bandbreite, die zur Übertragung der mindestens einen ersten Information in der zur Übertragung der mindestens einen ersten Information verwendeten Zeit notwendig ist. Dem Abtasten und/oder Sampling kann eine Signalaufbereitung, beispielsweise Filterung oder Mischung vorausgehen.

Mit Vorteil ist die erste Frequenzbandbreite, die Frequenzbandbreite des dem Analog-Digital-Wandler zugeführten Signals und/oder der Bandbreite die zur Übertragung der mindestens einen ersten Information in der verwendeten Zeit der Übertragung der mindestens einen ersten Information notwendig ist und/oder verwendet wird 50 MHz oder weniger, insbesondere 16MHz oder weniger. Bei derartigen Bandbreiten ist die Genauigkeitsverbesserung und Angriffssicherheitsverbesserung gegen Relais-Angriffe durch das erfindungsgemäße Verfahren besonders ausgeprägt.

Mit Vorteil beträgt die Auflösung und/oder Bittiefe, also insbesondere die Feinheit der digitalen Umwandlung, der ersten Abtastung mehr als 1 Bit, insbesondere mehr als 6 Bit, bevorzugt mehr als 12 Bit. Dies erhöht die Genauigkeit des Verfahrens.

Erfindungsgemäß wird mindestens ein erster Abtastwert des mindestens einen ersten analogen Signals, gegebenenfalls nachdem das Signal weiterbearbeitet, insbesondere heruntergemischt und/oder gefiltert wurde, insbesondere mittels Tiefpass, verwendet, der insbesondere mittels des mindestens einen ersten Analog-Digital-Wandlers gewonnen wurde, um eine zeitlichen Lage und/oder Phasenlage zu bestimmen. Dabei liegt der mindestens eine erste Abtastwert in einer steigenden oder fallenden Flanke des mindestens einen ersten analogen Signals und/oder des mindestens einen ersten empfangenen analogen Signals, was beispielsweise aus dem Abtastwert selbst und/oder dem Verlauf benachbarter Abtastwerte erkannt werden kann.

Unter Flanke ist insbesondere jede Veränderung des analogen Signals, beispielsweise in Bezug auf Amplitude, Frequenz, Phase, I und/oder Q Wert zu verstehen, die sich unter Annahme von mindestens zehn Zwischenwerten (die nicht alle abgetastet werden müssen), insbesondere kontinuierlich und/oder monoton, von einem ersten Wert zu einer ersten Zeit auf einen zweiten Wert zu einer zweiten Zeit ändert, wobei die Zwischenwerte zwischen dem ersten und dem zweiten Wert liegen und zwischen der ersten und der zweiten Zeit eingenommen werden und wobei insbesondere die Zwischenwerte im zeitlichen Verlauf von der ersten zu der zweiten Zeit monoton ansteigen oder monoton fallen, insbesondere streng monoton, insbesondere äquidistant in Bezug auf Wert und/oder Zeit verteilt sind, insbesondere bei Betrachtung des Signals ohne Multipatheffekte, Störungen und/oder Überlagerungen des Signals und/oder des Signals bei seiner Abstrahlung.

Erfindungsgemäß wird zusammen mit Kenntnis über den Verlauf der Flanke im mindestens einen ersten analogen Signal, insbesondere am Sender und/oder ersten Objekt, die zeitliche Lage des mindestens einen ersten Abtastwertes im mindestens einen ersten analogen Signal, insbesondere im und/oder am zweiten Objekt, und dadurch die zeitliche Lage und/oder Phasenlage des ersten analogen Signals zu einer ersten Referenzzeit, auch Referenztakt, insbesondere am und/oder im ersten und/oder zweiten Objekt, bestimmt und/oder wird in Abhängigkeit von der zeitlichen Lage des Signals, insbesondere im und/oder am zweiten Objekt eine Aktion, insbesondere im und/oder am zweiten Objekt, durchgeführt, insbesondere wird vom zweiten Objekt ein erstes Antwortsignal abgestrahlt, insbesondere derart, dass zwischen der zeitlichen Lage und/oder Phasenlage des ersten analogen Signals, insbesondere im und/oder am zweiten Objekt, und des ersten Antwortsignals, insbesondere im und/oder am zweiten Objekt, insbesondere einer Flanke des ersten Antwortsignals und/oder zwischen dem Empfang und/oder dem Abtasten des mindestens einen ersten Signals, insbesondere der Flanke des mindestens einen ersten analogen Signals, insbesondere im und/oder am zweiten Objekt, und dem Abstrahlen des ersten Antwortsignals, insbesondere einer Flanke des ersten Antwortsignals, eine, insbesondere vorbestimmte Beziehung besteht und/oder diese Beziehung an das erste Objekt und/oder eine Auswerteeinheit übertragen wird.

Insbesondere sind das erste und das zweite Objekt voneinander beabstandet und/oder relativ zueinander beweglich. Insbesondere wird das erste analoge Signal mittels Funk und/oder Kabel vom ersten an das zweite Objekt übertragen.

Vorteilhafterweise handelt es sich um ein bidirektionales, insbesondere digitales, Datenübertragungssystem, wobei nicht unbedingt Nutzdaten bidirektional übertragen werden müssen, eine Übertragung von Nutzdaten in eine Richtung und Übertragung zum Beispiel von Quittierungsdaten in die andere reicht aus.

Insbesondere wird mittels des Übertragungssystems mindestens eine zweite, insbesondere digitale, Information in mindestens einem zweiten analogen Signal codiert vom zweiten zum ersten Objekt, insbesondere mittels mindestens einem zweiten elektrischen, magnetischen oder elektromagnetischen Signal übertragen. Dabei wird insbesondere am und/oder im zweiten Objekt zum Senden des mindestens einen zweiten elektrischen, magnetischen oder elektromagnetischen Signal die zweiten Informationen in das mindestens eine erste analoge Signal mit einer zweiten Frequenzbandbreite gewandelt, insbesondere mittels eines Modulation- und/oder Codierverfahren, wie QAM, FSK, insbesondere GFSK, und insbesondere mittels der mindestens einen zweiten elektromagnetischen Signal gesendet. Dabei kann das zweite analoge Signale vor dem Senden weiter bearbeitet, insbesondere mit einer Trägerfrequenz gemischt und/oder gefiltert, werden. Das mindestens eine zweite analoge Signal kann das mindestens eine zweite magnetische, elektrische oder elektromagnetische Signal darstellen. Es ist zum Beispiel aber auch denkbar, dass das mindestens eine zweite magnetische, elektrische oder elektromagnetische Signal durch Mischen des zweiten analogen Signals mit einer Trägerfrequenz erzeugt wird.

Insbesondere wird nach dem Empfang des mindestens einen zweiten elektrischen, magnetischen oder elektromagnetischen Signal und/oder des zweiten analogen Signal, insbesondere am und/oder im ersten Objekt, eine Umwandlung des mindestens einen zweiten magnetischen, elektrischen oder elektromagnetischen Signals und/oder des zweiten analogen Signals in empfangene zweite digitale Information, insbesondere mittels mindestens eines zweiten Analog-Digital-Wandler, insbesondere am und/oder im ersten Objekt, durchgeführt.

Insbesondere wird, insbesondere mit dem mindestens einen zweiten Analog-Digital-Wandler, mindestens eine erste Abtastung und/oder ein Sampling, insbesondere des zweiten analogen Signals und/oder des mindestens einen zweiten magnetischen, elektrischen oder elektromagnetischen Signals, (auch eine mindestens zweite Abtastung genannt), insbesondere im und/oder am ersten Objekt, mit einer zweiten Abtast- und/oder Samplingrate durchgeführt. Insbesondere ist die zweite Abtast- und/oder Samplingrate mindestens doppelt so groß und/oder schnell wie die zweite Frequenzbandbreite, wie die Frequenzbandbreite des dem zweiten Analog-Digital-Wandler zugeführten Signal und/oder wie die Bandbreite, die zur Übertragung der mindestens einen zweiten Information in der zur Übertragung der mindestens einen zweiten Information verwendeten Zeit notwendig ist.

Mit Vorteil ist die zweite Frequenzbandbreite, die Frequenzbandbreite des dem zweiten Analog-Digital-Wandler zugeführten Signals und/oder die Bandbreite die zur Übertragung der mindestens einen zweiten Information in der verwendeten Zeit der Übertragung der mindestens einen zweiten Information notwendig ist und/oder verwendet wird, und/oder insbesondere 50 MHz oder weniger, insbesondere 16MHz oder weniger. Bei derartigen Bandbreiten ist die Genauigkeitsverbesserung und Angriffssicherheitsverbesserung gegen Relais-Angriffe durch das erfindungsgemäße Verfahren besonders ausgeprägt.

Mit Vorteil beträgt die Auflösung und/oder Bittiefe, also insbesondere die Feinheit der digitalen Umwandlung, der ersten Abtastung des zweiten Signals mehr als 1 Bit, insbesondere mehr als 6 Bit, bevorzug mehr als 12 Bit. Dies erhöht die Genauigkeit des Verfahrens.

Vorteilhafterweise wird der mindestens eine erste Abtastwert des mindestens einen zweiten analogen Signals, der auch als mindestens ein zweiter Abtastwert bezeichnet werden kann und insbesondere ein Abtastwert des zweiten Analog-Digital-Wandlers ist, verwendet, um eine zeitlichen Lage und/oder Phasenlage zu bestimmen. Dabei kann der mindestens eine zweite Abtastwert auch ermittelt werden, nachdem das Signal weiterbearbeitet, insbesondere heruntergemischt und/oder gefiltert wurde, insbesondere mittels Tiefpass.

Dabei liegt der mindestens eine zweite Abtastwert in einer steigenden oder fallenden Flanke des mindestens einen zweiten analogen Signals und/oder zweiten empfangenen analogen Signals, was beispielsweise aus dem Abtastwert selbst und oder dem Verlauf benachbarter Abtastwerte erkannt werden kann.

Vorteilhafterweise wird zusammen mit Kenntnis über den Verlauf der Flanke im mindestens einen zweiten analogen Signals die zeitliche Lage und/oder Phasenlage des zweiten analogen Signals zu einer zweiten Referenzzeit, auch zweiter Referenztakt, insbesondere am und/oder im ersten Objekt, bestimmt und/oder wird in Abhängigkeit von der zeitlichen Lage des Signals, insbesondere im und/oder am ersten Objekt eine Aktion, insbesondere im und/oder am ersten Objekt, durchgeführt, insbesondere wird vom ersten Objekt ein zweites Antwortsignal abgestrahlt, insbesondere derart, dass zwischen der zeitlichen Lage und/oder Phasenlage des zweiten analogen Signals, insbesondere im und/oder am ersten Objekt, und des zweiten Antwortsignals, insbesondere im und/oder am ersten Objekt, und/oder zwischen dem Empfang und/oder dem Abtasten des mindestens einen zweiten Signals, insbesondere im und/oder am ersten Objekt, und dem Abstrahlen des zweiten Antwortsignals eine, insbesondere vorbestimmte, Beziehung besteht und/oder diese Beziehung an das zweite Objekt und/oder die Auswerteeinheit übertragen wird.

Mit besonderem Vorteil stellt das erste Antwortsignal mindestens ein zweites analoges Signal dar und/oder enthält das erste Antwortsignal mindestens ein zweites analoges Signal. Mit besonderem Vorteil stellt das zweite Antwortsignal mindestens ein erstes analoges Signal dar und/oder enthält das zweite Antwortsignal mindestens ein erstes analoges Signal.

Mit Vorteil wird das Verfahren mehrfach wiederholt und insbesondere eine Mittelung der zeitlichen Lagen, Laufzeiten und/oder Phasenverschiebungen der einzelnen Wiederholungen vorgenommen. Dabei kann insbesondere jede Flanke eines analogen Signals zur Durchführung des Verfahrens verwendet werden, solche Flanken sind bei analogen Signale, in denen, insbesondere digitale, Informationen codiert sind, zahlreich vorhanden. Mit Vorteil wird das Verfahren wiederholt unter Verwendung unterschiedlicher Antennen am ersten und/oder zweiten Objekt durchgeführt und/oder zeitgleich mehrfach unter Verwendung mehrerer, insbesondere unterschiedlicher Antennen am ersten und/oder zweiten Objekt durchgeführt und/oder werden zur Abstrahlung und/oder zum Empfang des mindestens einen ersten und/oder mindestens einen zweiten analogen Signal und/oder des mindestens einen ersten und/oder mindestens einen zweiten magnetischen, elektrischen oder elektromagnetischen Signal am ersten und/oder zweiten Objekt mehrere, insbesondere unterschiedliche, Antennen verwendet. Bei Verwendung mehrerer Antennen werden diese bevorzugt so verwendet, dass ihre Polarisationsrichtungen unterschiedlich sind, insbesondere senkrecht zueinander stehen.

Mit besonderem Vorteil wird das Verfahren bei einer Übertragung mittels I&O-Verfahren und/oder QAM mindestens zweifach, insbesondere parallel unter Verwendung mindestens einer Flanke des I Signals oder Signalanteils als erstes und/oder zweites analoges Signal und unter Verwendung mindestens einer Flanke des Q Signals oder Signalanteils als erstes und/oder zweites analoges Signal durchgeführt.

Vorteilhafterweise wird eine erste Signallaufzeit und/oder erste Phasenverschiebung des mindestens einen ersten analogen Signals vom ersten zum zweiten Objekt und/oder eine zweite Signallaufzeit und/oder zweite Phasenverschiebung des mindestens einen zweiten analogen Signals vom zweiten zum ersten Objekt und/oder eine Rundlaufsignallaufzeit und/oder Rundlaufphasenverschiebung des mindestens einen ersten analogen Signals und des mindestens einen zweiten analogen Signals vom ersten Objekt über das zweiten Objekt zum ersten Objekt bestimmt.

Dies kann beispielsweise dadurch erfolgen, dass das erste analoge Signal eine Flanke, beginnend zu einer ersten Zeit, aufweisend am ersten Objekt gesendet wird und das zweite Objekt die Zeit des Empfangs mindestens eines ersten Abtastwertes in der Flanke des empfangenen ersten analogen Signal relativ zu einem Referenztakt bestimmt und ein erstes Antwortsignal abstrahlt, das ein zweites analoges Signal mit einer Flanke, beginnend zu einer zweiten Zeit, beinhaltet oder darstellt und das zweite Objekt die mindestens eine zwischen Empfang des mindestens einen ersten Abtastwertes der Flanke des ersten analogen Signals und Abstrahlen des Begins der Flanke des zweiten analogen Signals vergangene erste Zeitspanne an das erste Objekt und/oder eine Auswerteinrichtung überträgt. Das erste und/oder zweite Objekt und/oder die Auswerteinrichtung bestimmt zudem die mindestens eine zwischen Abstrahlen des dem mindestens einen ersten Abtastwert entsprechenden Wertes der Flanke des ersten analogen Signals und Empfang mindestens eines zweiten Abtastwertes in der Flanke des zweiten analogen Signals vergangene zweite Zeitspanne. Das erste und/oder zweite Objekt und/oder die Auswerteinrichtung bestimmt darüber hinaus die mindestens eine zwischen Abstrahlung des Begins der Flanke des zweiten analogen Signals und Abstrahlung mindestens eines dem mindestens einen zweiten Abtastwert entsprechenden Wertes in der Flanke des zweiten analogen Signals vergangene dritte Zeitspanne. Aus den Zeitspannen lässt sich die Rundlaufzeit und somit die Entfernung bestimmen, indem die Rundlaufzeit als zweite Zeitspanne minus erster Zeitspanne und minus dritter Zeitspanne angenommen wird. Dabei ist jedem Paar von erstem des ersten Signals Abtastwert und erstem Abtastwert des zweiten Signals eine erste, eine zweite und eine dritte Zeitspanne zugeordnet. Über die sich aus verschiedenen ersten, zweiten und dritten Zeitspannen ergebenen Rundlaufzeiten kann gemittelt werden.

Vorteilhafterweise wird aus der ersten und/oder zweiten Signallaufzeit und/oder ersten und/oder zweiten Phasenverschiebung und/oder Rundlaufsignallaufzeit und/oder Rundlaufphasenverschiebung eine Entfernung zwischen dem ersten und zweiten Objekt bestimmt.

Vorteilhafterweise wird der Signalverlauf, insbesondere die Anordnung und/oder die Ausgestaltung und/oder der Verlauf der Flanken, des mindestens einen ersten und/oder zweiten analogen Signals vom ersten zum zweiten Objekt und/oder umgekehrt und/oder an eine Auswerteinrichtung kommuniziert, insbesondere verschlüsselt. Vorteilhafterweise wird die zeitliche Lage und/oder Phasenlage des zweiten analogen Signals und/oder mindestens eines zweiten Abtastwertes und insbesondere der mindestens eine zweite Abtastwert in einer Flanke des zweiten Signals am ersten Objekt, vom ersten und zum zweiten Objekt und/oder an die Auswerteinrichtung kommuniziert.

Vorteilhafterweise wird die zeitliche Lage und/oder Phasenlage des ersten analogen Signals und/oder dessen Flanke am zweiten Objekt und/oder mindestens eines ersten Abtastwertes und insbesondere der mindestens eine erste Abtastwert in einer Flanke des ersten Signals, vom zweiten zum ersten Objekt und/oder an die Auswerteinrichtung kommuniziert.

Vorteilhafterweise wird der Zeitpunkt des Abstrahlens des ersten und/oder zweiten Signals und/oder mindestens einer Flanke des ersten und/oder zweiten Signals an das erste oder zweite Objekt und/oder die Auswerteeinrichtung kommuniziert.

In Multipathumgebungen werden Flanken eines ersten oder zweiten Signals bei der Übertragung und/oder sind sie beim Empfang am Empfänger durch Überlagerungen verschiedener Übertragungswege verändert, beispielsweise verschlissen.

In solchen Fällen ist es teilweise nicht mehr möglich einen einzelnen Abtastwert des empfangenen Signals einem Punkt im abgestrahlten Signal zuzuordnen. Meist ist es dann erst durch die Nahme zahlreicher Messerte und deren Verarbeitung möglich, eine Zuordnung herzustellen und/oder die Flanke des Signalanteils eines oder weniger Ausbreitungswege zu ermitteln. Auch ist es meist nicht oder nur mit unzumutbarem Aufwand möglich, die Form der Flanke am Empfänger aus dem abgestrahlten Signal zu errechnen. Insbesondere in solchen Fällen beinhaltet das Verfahren insbesondere das Senden eines ersten Testsignals mit mindestens einer Testflanke vom ersten zum zweiten Objekt und/oder das Senden eines zweiten Testsignals mit mindestens einer Testflanke vom zweiten zum ersten Objekt und das Vermessen zumindest eines Abschnitts der Testflanke des ersten Signals am zweiten Objekt und/oder des zweiten Testsignals am ersten Objekt und, insbesondere mehrfache, Durchführung des Verfahrens mit einem ersten und/oder zweiten Signal, wobei die Testflanke ähnlich zur oder identisch zur Flanke im ersten und/oder zweiten Signal ist, insbesondere das erste und/oder zweite Signal ähnlich zum oder identisch zum Testsignal ist.

Insbesondere beinhaltet das Verfahren das mehrfache Senden eines ersten Testsignals mit mindestens einer Testflanke vom ersten zum zweiten Objekt und/oder das mehrfache Senden eines zweiten Testsignals mit mindestens einer Testflanke vom zweiten zum ersten Objekt und das Vermessen zumindest eines Abschnitts der Testflanke des ersten Testsignals am zweiten Objekt und/oder des zweiten Testsignals am ersten Objekt durch zwischen den Wiederholungen zeitlich versetztes Sampling des empfangenen Testsignals und rekonstruieren der empfangenen Testflanke aus den zeitlich versetzten Samplings der Testflanken des mehrfachen Sendens bzw. deren Empfang, dies unter der Annahme, dass die Änderung der Umgebungseinflüsse über die Dauer der Wiederholungen zu vernachlässigen ist und insbesondere die Testflanken der mehrfachen Übertragung identisch empfangen werden. Insbesondere ist das mehrfache Senden ein mindestens 5-faches, insbesondere mindestens 10-faches, Senden. Insbesondere findet das mehrfache Senden in einer Zeitspanne von weniger als 10s, insbesondere weniger als 1s, insbesondere weniger als 500ms statt.

Auch kann meist angenommen werden, dass der Einfluss der Umgebung unabhängig von der Richtung der Übertragung zwischen erstem und zweitem Objekt ist und somit das Vermessen und/oder die Kenntnis über die Veränderung der durch die Übertragung in eine Richtung und/oder das Vermessen und/oder die Kenntnis der am ersten oder zweiten Objekt empfangenen Flanke und/oder Testflanke ausreicht.

So kann eine Wiederholung der Abstrahlung mit einer Wiederholfrequenz FW erfolgen und kann das Sampling mit einer Frequenz FS erfolgen, wobei zwischen den einzelnen Wiederholungen des Sendens oder des Empfangs der Wiederholungen des Sendens, das Sampling des empfangenen Signals zeitlich so verändert wird, dass die zeitliche Lage der Samplings relativ zum abgestrahlten Signal um einen zeitliche Betrag kleiner der Zeit zwischen zwei Samplings verschoben wird und insbesondere mindestens fünf, insbesondere mindestens 10, Samplings an unterschiedlichen zeitlichen Positionen in den Wiederholungen der Testflanke genommen werden.

Insbesondere stellt das Testsignal oder beinhaltet das Testsignal ein erstes oder zweites Signal, insbesondere einer vorausgehenden oder nachfolgenden Durchführung des Verfahrens und/oder eines vorausgehendes oder nachfolgenden ersten oder zweitens Signals der Durchführung des Verfahrens dar. Das Testsignal kann auch das erste Signal oder das zweite Signal der Durchführung des Verfahrens darstellen oder beinhalten, bei der die aus dem Testsignal gewonnene Kenntnis über die Flanke verwendet wird.

Insbesondere wird das Verfahren so durchgeführt, dass angenommen wird, dass die Veränderung bei der Übertragung des ersten oder zweiten Testsignals identisch oder näherungsweise identisch zu der Veränderung bei der Übertragung der weiteren ersten oder zweiten Testsignale und/oder zu der Veränderung bei der Übertragung des zweiten Signals vom zweiten zum ersten Objekt ist, insbesondere wenn die Flanke im ersten Signal mit der im zweiten Signal identisch und/oder näherungsweise identisch ist und/oder dass angenommen wird, dass die Veränderung bei der Übertragung eines ersten Signals einer ersten Ausführung der Schritte vom ersten zum zweiten Objekt identisch oder näherungsweise identisch zu der Veränderung bei der Übertragung eines zweiten ersten Signals vom zweiten zum ersten Objekt ist, insbesondere wenn die Flanke im ersten Signal mit der im zweiten Signal identisch und/oder näherungsweise identisch ist.

Bevorzugt werden erste und zweite Objekte und/oder die Verwendung von ersten und zweiten Objekten, die so ausgestaltet sind, dass sie ein erstes und/oder zweites Signal identisch abstrahlen und/oder identisch empfangen und/oder abtasten. Insbesondere weisen sie baugleiche Sende- und/oder Empfangseinheiten und/oder baugleiche Abtastmittel, baugleiche Analog-Digital-Wandler, baugleiche Digital-Analog-Wandler, baugleiche Antennen, baugleiche Antennenanordnungen und/oder baugleiche Oszillatoren auf.

Insbesondere kann dadurch durch einmaliges Vermessen der Veränderung oder eines Empfangs der Flanke oder Testflanke, insbesondere unter Rekonstruktion der Testflanke aus der Vermessung mehrerer Wiederholungen des Sendens und/oder Empfangs der Testflanke, und mehrfache Verwendung der Kenntnis das Verfahren sehr effizient und schnell durchgeführt werden. Auch kann es dadurch ausreichen, die Mittel zum Vermessen und/oder zur Rekonstruktion nur am ersten oder zweiten Objekt vorzusehen, dies ist insbesondere vorteilhaft, wenn eines der Objekte ein tragbares Gerät, beispielsweise Schlüssel oder Mobiltelefon, ist oder das Verfahren mit zahlreichen ersten oder zahlreichen zweiten Objekten durchgeführt werden soll. Das versetzte Sampling von wiederholten Testsignalen ermöglicht es dabei, das Verfahren zuverlässig auch in komplexeren Umgebungen mit einfacher und preisgünstiger Hardware durchzuführen.

Insbesondere wird/werden pro erstem und/oder zweitem Signal, sofern es sich nicht um ein Testsignal handelt, nur weniger als 10 Abtastwerte pro Flanke genommen. Insbesondere wird/werden pro erstem oder zweiten Signal nur fünf oder weniger Abtastwerte pro Flanke genommen. Insbesondere werden die Abtastwerte von mindestens 5 Wiederholungen der Abstrahlung der Testflanke kombiniert und/oder gemeinsam verwendet, insbesondere zur Rekonstruktion der Testflanke.

Vorteilhafterweise wird die Zeitspanne zwischen erstens dem Empfang und/oder Sampling des mindestens einen ersten Signals am zweiten Objekt und/oder des mindestens einen ersten Abtastwertes in einer Flanke des ersten Signals am zweiten Objekt und zweitens dem Abstrahlen des Antwortsignals, das insbesondere ein zweites Signal darstellt, oder einer Flanke im zweiten Signal an das erste Objekt und/oder die Auswerteeinrichtung kommuniziert und/oder ist diese Zeitspanne dem ersten Objekt und/oder der Auswerteeinheit bekannt, insbesondere weil sie immer identisch gewählt wird.

Mit besonderem Vorteil beträgt die erste und/oder zweite Abtastrate mindestens das 1,8-fache, insbesondere mindestens das Zweifache, insbesondere mindestens das 3,8-fache, der Symbolrate des ersten und/oder zweiten analogen Signals, der ersten und/oder zweiten Frequenzbandbreite, der Frequenzbandbreite des dem Analog-Digital-Wandler zugeführten ersten oder zweiten Signals und/oder der Bandbreite, die zur Übertragung der mindestens einen ersten und/oder zweiten Information in der zur Übertragung der mindestens einen ersten bzw. zweiten Information verwendeten Zeit notwendig ist und/oder der Chiprate des ersten und/oder zweiten analogen Signals.

Mit Vorteil werden mehrere erste Abtastungen des ersten und/oder zweiten analogen Signals durchgeführt und verwendet und/oder der Verlauf der Flanke des ersten und/oder zweiten analogen Signals, Auflösung und/oder Bittiefe der ersten Abtastung des ersten und/oder zweiten analogen Signals so gewählt, dass über den Verlauf der Flanke des ersten und/oder zweiten analogen Signals mindestens zwei, insbesondere mindestens drei Abtastungen durchgeführt werden, die insbesondere unterschiedliche Abtastwerte aufweisen.

Mit besonderem Vorteil wird das Verfahren mindestens n-fach unter Verwendung von mindestens n unterschiedlichen Kombinationen erster Objekte und zweiter Objekte wiederholt, wobei an jeder der n Kombinationen als erstes oder zweites Objekt ein an allen Kombinationen beteiligtes einheitliches und/oder dediziertes Objekt beteiligt ist und das andere aus erstem und zweitem Objekt der Kombinationen so aus einer Menge von n Objekten gewählt ist, dass jedes der n Objekte, mindestens in einer der mindestens n Wiederholung des Verfahrens und/oder n Kombinationen ein erstes oder zweites Objekt darstellt. So wird abgesehen von maximal einem der n Objekte das Verfahren mindestens einmal unter Nutzung jedes der n Objekte als erstes oder zweites Objekt durchgeführt. Auch wird abgesehen von maximal einem der n Objekte das Verfahren mindestens einmal unter Nutzung jedes der n Objekte als zweites Objekt durchgeführt. Insbesondere handelt es sich bei dem einheitlichen und/oder dedizierten Objekt um ein tragbares und/oder mobiles Objekt und/oder um ein Mobiltelefon und/oder ein, insbesondere funkbasiertes, Authentifizierungsmittel, wie beispielsweise ein digitaler und/oder Funk-Schlüssel.

Mit besonderem Vorteil wird das Verfahren mindestens n-fach unter Verwendung von mindestens n unterschiedlichen Kombinationen erster Objekte und zweiter Objekte wiederholt, wobei die ersten und zweiten Objekte der Kombinationen so aus einer Menge von n Objekten gebildet sind, dass jedes der n Objekte, abgesehen von maximal einem der n Objekte, mindestens in einer der mindestens n Wiederholung ein erste Objekt und in mindestens einer anderen der mindestens n Wiederholungen ein zweites Objekt darstellt. So wird abgesehen von maximal einem der n Objekte das Verfahren mindestens einmal unter Nutzung jedes der n Objekte als erstes Objekt durchgeführt. Auch wird abgesehen von maximal einem der n Objekte das Verfahren mindestens einmal unter Nutzung jedes der n Objekte als zweites Objekt durchgeführt. Dabei wird insbesondere die Kommutation und/oder Variation einer Kombination als identisch zu der Kombination betrachtet. Bei den Kombinationen handelt es sich insbesondere um Kombinationen ohne Wiederholung.

In beiden zuvor geschilderten vorteilhaften Ausführungen werden insbesondere die bestimmten zeitliche Lagen des jeweiligen ersten analogen Signals, insbesondere zu einer Referenzzeit, und/oder daraus abgeleitete Informationen, insbesondere Entfernungen und/oder Positionen der und/oder zwischen den Objekten, n-Objekten und/oder einer Auswahl der n Objekte im und/oder an einem gemeinsamen Ort, insbesondere an einem der Objekte, insbesondere dem einheitlichen einheitlichen und/oder dedizierten Objekt, insbesondere am jeweiligen zweiten Objekt aller Wiederholungen an einem gemeinsamen Ort bereitgestellt und insbesondere verarbeitet. Die Bereitstellung kann beispielsweise durch eine Übertragung realisiert werden. Durch die zentrale Bereitstellungen können die relativen Abstände zentral bestimmt werden. Insbesondere wird bei jeder Ausstrahlung eines ersten Signals durch ein als erstes Objekt verwendetes der n Objekte das Signal von mindestens einem anderen und/oder an der Kombination nicht beteiligten, insbesondere von allen anderen, der n Objekte empfangen und das Verfahren für jedes der empfangen Objekte, insbesondere für jedes der nicht zur Ausstrahlung des ersten Signals verwendeten Objekte, als zweites Objekt durchgeführt zusammen mit dem zur Ausstrahlung verwendeten ersten Objekt. Dadurch lassen sich pro erstem Signal n-1 zeitliche Lagen bestimmen.

Insbesondere wird bei jeder Ausstrahlung eines zweiten Signals durch ein als zweites Objekt verwendetes der n Objekte das Signal von mindestens einem anderen und/oder an der Kombination nicht beteiligten, insbesondere von allen anderen, der n Objekte empfangen und das Verfahren für jedes der empfangen Objekte, insbesondere für jedes der nicht zur Ausstrahlung des zweiten Signals verwendeten Objekte, als erstes Objekt durchgeführt zusammen mit dem zur Ausstrahlung verwendeten zweiten Objekt.

Insbesondere sind die n Objekte ortsfest positioniert. Insbesondere ist ihre Position dem zweiten Objekt bekannt und/oder Insbesondere ist ihre Position an dem gemeinsamen Ort bekannt.

Insbesondere ist n mindestens gleich zwei, insbesondere größer als drei.

Mit besonderem Vorteil wird bei allen mindestens n Wiederholungen des Verfahrens das erfindungsgemäße Verfahren zusätzlich zwischen dem jeweiligen ersten Objekt (aus den n Objekten) der jeweiligen Wiederholung und einem bei allen mindestens n Wiederholungen einheitlichen und/oder dedizierten zweiten Objekt, das insbesondere nicht Teil der n Objekte ist, durchgeführt.

Insbesondere werden die bestimmten zeitliche Lagen des ersten analogen Signals zu einer Referenzzeit im und/oder am für alle Wiederholungen einheitlichen und/oder dedizierten zweiten Objekt an dem einen gemeinsamen Ort bereitgestellt und insbesondere verarbeitet und/oder ist der eine gemeinsame Ort das für alle Wiederholungen einheitliche und/oder dedizierte zweite Objekt.

Mit besonderem Vorteil werden bei allen mindestens n Wiederholungen des Verfahrens von einem weiteren bei allen mindestens n Wiederholungen einheitlichen und/oder dedizierten zweiten Objekt erstes und/oder zweites Signal empfangen, auch "mitgehört", das insbesondere nicht Teil der n Objekte ist. Dieses einheitliche Objekt nimmt insbesondere mindestens einen ersten Abtastwert jedes ersten und/oder zweiten Signals der mindestens n Wiederholungen des Verfahrens in einer steigenden oder fallenden Flanke des ersten und/oder zweiten analogen Signals. Insbesondere wird zusammen mit Kenntnis über den Verlauf der Flanke im ersten und/oder zweiten analogen Signal die zeitliche Lage des mindestens einen ersten Abtastwerts im einen ersten und/oder zweiten analogen Signal und dadurch insbesondere die zeitliche Lage des ersten und/oder zweiten analogen Signals zu einer Referenzzeit im und/oder am einheitlichen und/oder dedizierten Objekt bestimmt.

Dabei ist das für alle Wiederholungen einheitliche zweite Objekt insbesondere nicht ortsfest, insbesondere ist seine Position vor Durchführung des Verfahrens nicht bekannt. Insbesondere wird mittels des Verfahrens seine Position und/oder Orientierung, zumindest relativ zu den n Objekten, bestimmt. Insbesondere ist das für alle Wiederholungen einheitliche zweite Objekt ein tragbares Objekt, insbesondere ein Mobiltelefon.

Gelöst wird die Aufgabe auch durch ein Verfahren zur Sicherung eines Zugangssystems, insbesondere zu einem Kraftfahrzeug, aufweisend ein Autorisierungsmittel, insbesondere einen Funkschlüssel und/oder Handy, und ein Zugangskontrollmittel, insbesondere im Kraftfahrzeug, wobei das Zugangskontrollmittel, insbesondere ein Schloss, eine Barriere und/oder ein Sicherungsmittel steuert, wobei zwischen dem Autorisierungsmittel und dem Zugangskontrollmittel elektrische, magnetische oder elektromagnetische Signale, insbesondere Wellen, übertragen werden, wobei die Signallaufzeit und/oder Signalrundlaufzeit zwischen Autorisierungsmittel und Zugangskontrollmittel mittels dem vorstehenden Verfahren bestimmt wird, insbesondere mit einer oder mehreren der als vorteilhaft beschriebenen Ausgestaltungen, und bei Überschreiten einer vorbestimmten Signallaufzeit und/oder Signalrundlaufzeit oder einer vorbestimmten Entfernung zwischen Autorisierungsmittel und Zugangskontrollmittel und/oder bei Überschreiten einer vorbestimmten Abweichung von auf anderem Weg und/oder mittls anderem Verfahren bestimmter Signallaufzeit und/oder Signalrundlaufzeit oder Entfernung, insbesondere zwischen Autorisierungsmittel und Zugangskontrollmittel, der Zugang, Zutritt und/oder ein Öffnen, insbesondere durch das Zugangskontrollmittel verwehrt wird, wobei das Autorisierungsmittel ein erstes der beiden Objekte erstes und zweites Objekt und das Zugangskontrollmittel das zweite der beiden Objekte erstes und zweites Objekt darstellen. Dabei ist das Zugangssystem insbesondere so eingerichtet, dass das Autorisierungsmittel, insbesondere mittels der elektrischen, magnetischen oder elektromagnetischen Signale, das Zugangskontrollmittel dazu veranlassen kann, Zugang und/oder Zutritt zu gewähren, ein Öffnen durchzuführen und/oder ein Schloss, eine Barriere und/oder ein Sicherungsmittel zu öffnen. Das Zugangskontrollmittel und/oder Sicherungsmittel, kann auch durch Software und/oder einer Einheit aus Software und Hardware realisiert sein.

Gelöst wird die Aufgabe auch durch ein, insbesondere digitales, Übertragungssystem, mit Mitteln zur Analyse der zeitlichen Lage und/oder Phasenlage, insbesondere zur Laufzeitmessung, Phasenmessung oder Synchronisierung, wobei das Übertragungssystem mindestens zwei Objekte aufweist und eingerichtet ist, mindestens eine erste, insbesondere digitale, Information in mindestens einem ersten analogen Signal codiert zwischen den zwei Objekten, insbesondere mittels mindestens einem ersten elektrischen, magnetischen oder elektromagnetischen Signal zu übertragen.

Gelöst wird die Aufgabe auch durch ein erstes Objekt, eingerichtet in Zusammenwirken mit einem zweiten Objekt das Verfahren durchzuführen und/oder ein Übertragungssystem zu bilden und/oder ein zweites Objekt eingerichtet in Zusammenwirken mit ersten zweiten Objekt das Verfahren durchzuführen und/oder ein Übertragungssystem zu bilden

Das erste Objekt und/oder das erste Objekt der zwei Objekte des Übertragungssystem ist insbesondere eingerichtet, zum Senden des mindestens einen ersten magnetischen, elektrischen oder elektromagnetischen Signals, und die mindestens eine erste Information in das mindestens eine erste analoge Signal mit einer ersten Frequenzbandbreite zu wandeln und mittels des mindestens einen ersten elektrischen, magnetischen oder elektromagnetischen Signals zu senden.

Das zweite Objekt und/oder das zweite Objekt der zwei Objekte des Übertragungssystem weist insbesondere mindestens einen ersten Analog-Digital-Wandler auf und/oder ist insbesondere eingerichtet, das mindestens eine erste elektrische, magnetische oder elektromagnetische Signal zu empfangen und insbesondere eine Umwandlung des mindestens einen ersten magnetischen, elektrischen oder elektromagnetischen Signals in empfangene erste, insbesondere digitale, Information, insbesondere mittels des mindestens einen ersten Analog-Digital-Wandlers, durchzuführen, wobei der mindestens eine erste Analog-Digital-Wandler eingerichtet ist, eine Abtastung mit einer ersten Abtastrate durchzuführen, wobei die erste Abtastrate insbesondere mindestens doppelt so groß und/oder schnell wie die erste Frequenzbandbreite, wie die Frequenzbandbreite des dem Analog-Digital-Wandler zugeführten Signal und/oder wie die Bandbreite, die zur Übertragung der mindestens einen ersten Information in der zur Übertragung der mindestens einen ersten Information verwendeten Zeit notwendig ist.

Insbesondere stellt das System, die Auswerteeinrichtung und/oder stellen die Objekte jeweils Hardware und Software Systeme dar, wobei sie insbesondere eine CPU und einen Speicher aufweisen, wobei insbesondere in dem Speicher ein Programm hinterlegt ist, um die beschriebenen Schritte, insbesondere ein erfindungsgemäßes Verfahren, durchzuführen und/oder anzusteuern, insbesondere in dem das Programm durch die CPU ausgeführt wird.

Mit Vorteil beträgt die Auflösung und/oder Bittiefe, also insbesondere die Feinheit der digitalen Umwandlung, der ersten Abtastung des ersten und/oder zweiten Signals und/oder des Analog-Digital-Wanlders mehr als 1 Bit, insbesondere mehr als 6 Bit, bevorzug mehr als 12 Bit. Dies erhöht die Genauigkeit des Systems.

Das System ist eingerichtet, mindestens einen ersten Abtastwert des mindestens einen ersten analogen Signals des mindestens einen ersten Analog-Digital-Wandlers in einer steigenden oder fallenden Flanke des mindestens einen ersten analogen Signals zu nehmen und diesen zu verwenden, um eine zeitlichen Lage und/oder Phasenlage dadurch zu bestimmen, dass aus dem mindestens einen ersten Abtastwert zusammen mit Kenntnis über den Verlauf der Flanke im mindestens einen ersten analogen Signal und/oder Phasenlage des mindestens einen ersten analogen Signals zu einer ersten Referenzzeit, auch Referenztakt, insbesondere am und/oder im zweiten Objekt, zu bestimmen und/oder in Abhängigkeit von der zeitlichen Lage des Signals, insbesondere im und/oder am zweiten Objekt, eine Aktion, insbesondere im und/oder am zweiten Objekt, durchzuführen, insbesondere so, dass vom zweiten Objekt ein erstes Antwortsignal abgestrahlt wird, insbesondere derart, dass zwischen der zeitlichen Lage und/oder Phasenlage des ersten analogen Signals, insbesondere im und/oder am zweiten Objekt, und des ersten Antwortsignals, insbesondere im und/oder am zweiten Objekt und/oder zwischen dem Empfang und/oder dem Abtasten des mindestens einen ersten Signals, insbesondere im und/oder am zweiten Objekt, und dem Abstrahlen des ersten Antwortsignals eine, insbesondere vorbestimmte, Beziehung besteht und/oder diese Beziehung an das erste Objekt und/oder eine Auswerteeinheit übertragen wird.

Insbesondere ist das System eingerichtet, ein erfindungsgemäßes Verfahren durchzuführen. Insbesondere weist es eine Auswerteeinheit auf. Insbesondere weisen das erste und das zweite Objekt jeweils mindestens eine Antenne, mindestens einen Oszillator und/oder Frequenzsynthesizer sowie mindestens einen Analog-Digital-Wandler auf. Vorteilhafterweise weisen sie jeweils auch einen Mischer auf, bei mehreren Antennen, insbesondere auch einen Switch oder Umschalter zur Umschaltung zwischen den Antennen, einen Kontroller für Abläufe inklusive Timer, einen Digital-Analog-Wandler, einen Eingangsverstärker, einen Ausgansgsverstärker und/oder eine CPU.

Gelöst wird die Aufgabe auch durch ein Zugangssystems, insbesondere zu einem Kraftfahrzeug, aufweisend ein Autorisierungsmittel, insbesondere einen Funkschlüssel und/oder Handy, und ein Zugangskontrollmittel, insbesondere im Kraftfahrzeug, wobei das Zugangskontrollmittel, insbesondere eingerichtet ist, ein Schloss, eine Barriere und/oder ein Sicherungsmittel zusteueren, wobei zwischen dem Autorisierungsmittel und dem Zugangskontrollmittel elektrische, magnetische oder elektromagnetische Signale, insbesondere Wellen, übertragen werden, wobei das Zugangssystem insbesondere ein erfindungsgemäßes System wie oben beschrieben ist und eingerichtet ist, die Signallaufzeit und/oder Signalrundlaufzeit zwischen Autorisierungsmittel und Zugangskontrollmittel, insbesondere mittels dem vorstehenden Verfahren, zu bestimmen, insbesondere mit einer oder mehreren der als vorteilhaft beschriebenen Ausgestaltungen, und eingerichtet ist, bei Überschreiten einer vorbestimmten Signallaufzeit und/oder Signalrundlaufzeit oder einer vorbestimmten Entfernung zwischen Autorisierungsmittel und Zugangskontrollmittel und/oder bei Überschreiten einer vorbestimmten Abweichung von auf anderem Weg oder mittels anderem Verfahren und/oder anderer Vorrichtung bestimmter Signallaufzeit und/oder Signalrundlaufzeit oder Entfernung den Zugang, Zutritt und/oder ein Öffnen zu verwehren, wobei das Autorisierungsmittel ein erstes der beiden Objekte erstes und zweites Objekt und das Zugangskontrollmittel das zweite der beiden Objekte erstes und zweites Objekt darstellen. Dabei ist das Zugangssystem insbesondere so eingerichtet, dass das Autorisierungsmittel, insbesondere mittels der elektrischen, magnetischen oder elektromagnetischen Signale, das Zugangskontrollmittel dazu veranlassen kann, Zugang und/oder Zutritt zu gewähren, ein Öffnen durchzuführen und/oder ein Schloss, eine Barriere und/oder ein Sicherungsmittel zu öffnen.

Gelöst wird die Aufgabe auch durch die Verwendung mindestens eines ersten Abtastwertes mindestens eines ersten analogen Signals, insbesondere mindestens eines ersten Analog-Digital-Wandlers, zum zeitlich aufgelösten Erfassen der Lage und/oder Phasenlage des ersten analogen Signals, insbesondere einer Flanke des ersten analogen Signals, zu einer ersten Referenzzeit, auch Referenztakt, insbesondere am und/oder im zweiten Objekt, bestimmt und/oder in Abhängigkeit von der zeitlichen Lage des Signals, insbesondere im und/oder am zweiten Objekt eine Aktion durchzuführen, insbesondere im und/oder am zweiten Objekt, insbesondere zum Abstrahlen eines ersten Antwortsignals vom zweiten Objekt, insbesondere derart, dass zwischen der zeitlichen Lage und/oder Phasenlage des ersten analogen Signals, insbesondere im und/oder am zweiten Objekt, und des ersten Antwortsignals, insbesondere einer Flanke des ersten Antwortsignals, insbesondere im und/oder am zweiten Objekt, und/oder zwischen dem Empfang und/oder dem Abtasten des mindestens einen ersten analogen Signals, insbesondere im und/oder am zweiten Objekt, und dem Abstrahlen des ersten Antwortsignals eine, insbesondere vorbestimmte, Beziehung besteht und/oder diese Beziehung an das erste Objekt und/oder eine Auswerteeinheit übertragen wird und/oder zum zeitlich aufgelösten Erfassen der Lage des mindestens einen ersten analogen Signals und/oder einer Flanke des ersten analogen Signals relativ zu einer zweiten Referenzzeit.

Mit Vorteil beinhaltet die Verwendung auch die Verwendung mindestens eines ersten Abtastwertes mindestens eines zweiten analogen Signals, auch als mindestens ein zweiter Abtastwert bezeichnet, insbesondere mindestens eines ersten Analog-Digital-Wandlers, zum zeitlich aufgelösten Erfassen der Lage und/oder Phasenlage des zweiten analogen Signals, insbesondere einer Flanke des zweiten analogen Signals, zu einer zweiten Referenzzeit, auch Referenztakt, insbesondere am und/oder im ersten Objekt, und/oder in Abhängigkeit von der zeitlichen Lage des Signals, insbesondere um im und/oder am ersten Objekt eine Aktion durchzuführen, insbesondere im und/oder am ersten Objekt, insbesondere zum Abstrahlen eines zweiten Antwortsignals vom ersten Objekt, insbesondere derart, dass zwischen der zeitlichen Lage und/oder Phasenlage des zweiten analogen Signals, insbesondere im und/oder am ersten Objekt, und des zweiten Antwortsignals, insbesondere im und/oder am ersten Objekt, und/oder zwischen dem Empfang und/oder dem Abtasten des mindestens einen zweiten analogen Signals, insbesondere im und/oder am ersten Objekt, und dem Abstrahlen des zweiten Antwortsignals eine vorbestimmte Beziehung besteht und/oder diese Beziehung an das zweite Objekt und/oder die Auswerteeinheit übertragen wird und/oder zum zeitlich aufgelösten Erfassen der Lage des mindestens einen zweiten analogen Signals und/oder einer Flanke des zweiten analogen Signals relativ zu einer zweiten Referenzzeit.

Mit besonderem Vorteil stellt das erste Antwortsignal mindestens ein zweites analoges Signal dar und/oder enthält das erste Antwortsignal mindestens ein zweites analoges Signal. Mit besonderem Vorteil stellt das zweite Antwortsignal mindestens ein erstes analoges Signal dar und/oder enthält das zweite Antwortsignal mindestens ein erstes analoges Signal. Auch alle vorteilhaften Ausgestaltungen des Verfahrens lassen sich auf die Verwendung übertragen. Die Verwendung kann insbesondere ein erfindungsgemäßes System benutzen. Das Verfahren kann insbesondere unter Verwendung eines erfindungsgemäßen Systems durchgeführt werden.

Vorteilhafterweise beinhaltet das Verfahren und/oder die Verwendung die Ermittlung der Entfernung zwischen dem ersten und zweiten Objekt aus der erste und/oder zweiten Signallaufzeit und/oder und/oder erste und/oder zweiten Phasenverschiebung und/oder Rundlaufsignallaufzeit und/oder Rundlaufphasenverschiebung.

Vorteilhafterweise beinhaltet die Verwendung die Bestimmung einer ersten Signallaufzeit und/oder ersten Phasenverschiebung des mindestens einen ersten analogen Signals vom ersten zum zweiten Objekt und/oder einer zweiten Signallaufzeit und/oder zweiten Phasenverschiebung des mindestens einen zweiten analogen Signals vom zweiten zum ersten Objekt und/oder einer Rundlaufsignallaufzeit und/oder Rundlaufphasenverschiebung des mindestens einen ersten analogen Signals und des mindestens einen zweiten analogen Signals vom ersten Objekt über das zweiten Objekt zum ersten Objekt bestimmt.

Vorteilhafterweise wird das erste analoge Signal an dem ersten Objekt erzeugt und von diesem mittels elektromagnetischer, elektrischer oder magnetischer Signale an ein zweites Objekt übertragen und/oder der Abtastwert an dem zweiten Objekt ermittelt und ist insbesondere die erste Referenzzeit eine Zeit am zweiten Objekt und/oder die zweite Referenzzeit eine Zeit am ersten Objekt und/oder erfolgt das Auslösen und/oder Durchführen der Aktion am zweiten Objekt und/oder wird insbesondere das erste Antwortsignal vom zweiten Objekt abgestrahlt und/oder ist insbesondere die zeitliche Beziehung zwischen der zeitlichen Lage des ersten analogen Signals am zweiten Objekt und des erstes Antwortsignals am zweiten Objekt gegeben.

Weitere vorteilhafte Ausgestaltungen und Vorteile sollen rein exemplarisch und nicht beschränkend anhand der nachfolgenden Skizzen weiter erläutert werden. Dabei zeigen:
- Figur 1:: eine schematische Darstellung eines Sende- und Empfangsmoduls aus dem Stand der Technik
- Figur 2:: eine Veranschaulichung des Verfahrens

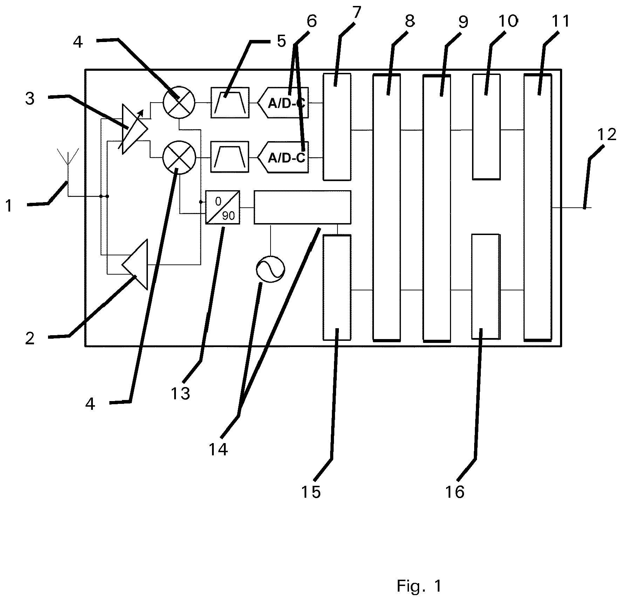

Figur 1 zeigt einen schematischen Aufbau eines Sende- und Empfangsmoduls aus dem Stand der Technik. Ein solches Modul ist beispielsweise durch den Chip CC25 von Texas Instruments gegeben. Ein solches Sende- und Empfangsmodul ist geeignet, mittels eines I&O Verfahren Daten zu übertragen, beispielsweise unter Verwendung des Bluetooth Standards.

Gezeigt ist eine extern an den Chip angeschaltet Antenne 1. Die von der Antenne empfangenen Signale werden über den Eingangsverstärker 3 geleitet und dann in zwei Signale aufgeteilt. Diese werden zwei Mischern 4 zugeleitet und sodann jeweils über einen Bandpassfilter 5 an jeweils einen Analog-Digital-Wandler 6 geleitet. Einem der Mischer 4 wird darüber hinaus ein im Frequenzsynthesizer 14 erzeugtes Signal zugeleitet, während dem anderen Mischer 4 das Signal des Frequenzsynthesizer 14 erst nach Passage eines Phasenschiebers 13 zugeleitet wird. So lassen sich aus den Mischern 4 die I und Q Signale erhalten. Nach dem Analog-Digital-Wandler 6 werden die I und Q Signale dann in digitaler Form dem dem Demodulator 7 zugeleitet und sodann über eine Fehlerkorrektur und Dekotiereinheit 8 an einen Pakethandler 9 und den Eingangsspeicher 10 übergeben. Von da aus gelangen sie an einen Schnittstellentreiber 11 durch diesen die Daten dann über den Eingang 12 bereitgestellt werden, beispielsweisezur Weiterverarbeitung mittels einer CPU.

Daten, die gesendet werden sollen, können über den Eingang 12 dem Schnittstellentreiber 11 übergegeben werden und werden sodann in einen Ausgangsspeicher 16 geschrieben und über den Pakethandler 9 an die Fehlerkorrektur und Codiereinheit 8 übergeben. Anschließend werden die so erzeugten Signale mittels eines Modulators 15 und dem Frequenzsynthesizer 14 an den Sendeverstärker 2 und die Antenne 1 übergeben.

Sofern ein solches Modul für ein erfindungsgemäßes Verfahren, Verwendung oder System verwendet werden soll, wären neben den üblicherweise über den Eingang 12 bereitgestellten Empfangsdaten auch weitere Samplingwerte oder Abtastwerte der Analog-Digital-Wandler 6 abzugreifen, die zwar in der Regel im Analog-Digital-Wandler 6 erhoben werden, üblicherweise nur in den unmittelbar nachfolgenden Stufen verwendet, dann aber nicht weitergegeben oder weiterverwendet werden, beispielsweise nicht aus dem verwendeten Chip, hier beispielsweise über den Eingang 12, herausgeleitet werden.

Die Abtastwerte könnten zwar prinzipiell über den Eingang 12 ebenfalls bereitgestellt werden, was mittels einer Änderung der Firmware möglich sein könnte. Aber auch andere Daten Ein- und/oder Ausgänge sind denkbar. Grundsätzlich reicht die beinhaltete Hardware zusammen mit einer CPU und einer entsprechenden Software, insbesondere in einem Speicher, aber aus, dass erfindungsgemäße Verfahren umzusetzen oder ein Objekt eines erfindungsgemäßen Systems zu bilden.

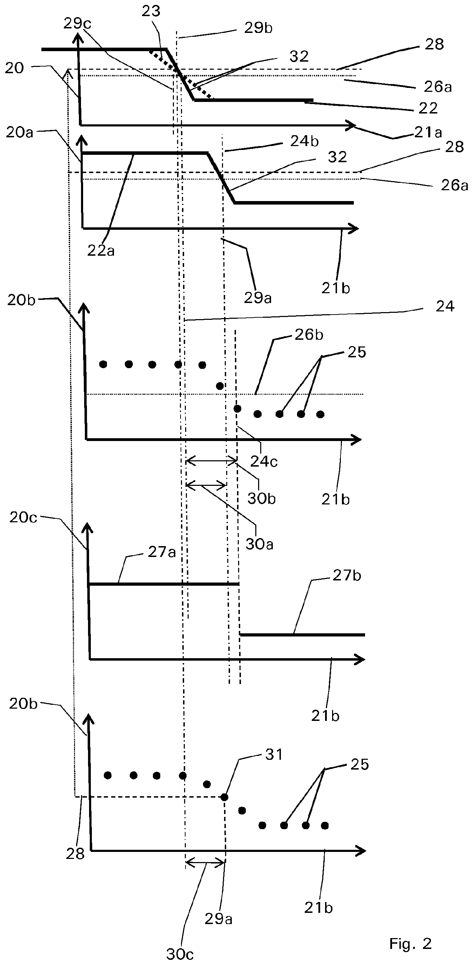

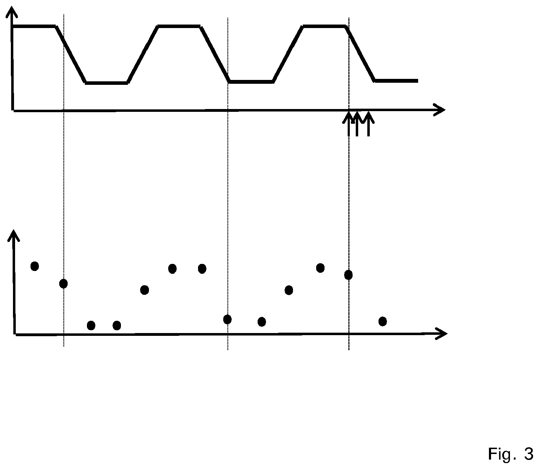

Figur 2 zeigt eine schematische Veranschaulichung des erfindungsgemäßen Verfahrens. Gezeigt sind übereinander mehrere Koordinatensysteme, die auf der horizontalen Achse jeweils eine Zeitachse zeigen und auf der vertikalen Achse jeweils die Ausprägung eines Signals darstellen. Dabei sind die einzelnen übereinander dargestellten Zeitachsen 21a, 21b zeitlich synchron angeordnet.

Das oberste Koordinatensystem mit der Zeitachse 21a zeigt ein analoges Signal 22 an einem ersten Objekt, das dieses Signal sendet. Die vertikale Achse 20 zeigt die Amplitude des Signals 22. Das Signal 22 verläuft zunächst konstant bei einem ersten Wert, bis es dann linear abfällt, um dann auf einem niedrigeren zweiten Wert konstant weiter zu verlaufen. Gezeigt ist darüber hinaus punktiert die mittlere Amplitude des Signals, nicht als Mittelwert 26a des Signals sondern als Mittelwert zwischen erstem und zweitem Wert. Gezeigt ist ausgehend von der Schnittstelle des Signals 22 und der mittleren Amplitude 26a eine vertikale Linie 24, die den Zeitpunkt der mittleren Amplitude am Sender darstellt.

Im darunter befindlichen Koordinatensystem, dem zweiten Koordinatensystem der Figur 2, ist der Signalverlauf 22a am Empfänger dargestellt in einem Koordinatensystem mit Zeitachse 21b und Amplitudenachse 20a. Der Signalverlauf 22a ist einer, der sich ohne weitere Störung und Verzerrung am Empfänger ergibt.

Zu erkennen ist, dass das Signal 22a am Empfänger um die Signallaufzeit 30a, zeitlicher Abstand zwischen Linie 29b und 29a, nach rechts verschoben ist. Gezeigt ist ebenfalls die mittlere Amplitude des Signals 26a, wie in der ersten Figur. Ausgehend von der Schnittstelle des Signals 22a und der mittleren Amplitude 26a ist eine vertikale Linie 24b gezeigt, die den Zeitpunkt der mittleren Amplitude am Empfänger darstellt.

Im Koordinatensystem darunter, im dritten Koordinatensystem, sind als Kreise Abtastwerte eines Analog-Digital-Wandlers des Signals 22a gezeigt. Diese sind dargestellt in einem Koordinatensystem mit Zeitachse am Empfänger 21b und Abtastwert am Empfänger 20b.

Dargestellt ist auch die Entscheidungsschwelle 26b des Empfängers. Bei einem Abtastwert oberhalb dieser Entscheidungsschwelle 26b wird eine logische "eins" angenommen, bei einem Abtastwert unterhalb dieser Entscheidungsschwelle wird eine logische "null" angenommen. Hier dargestellt ist die Entscheidungsschwelle bei dem Wert der mittleren Amplitude. Sie kann aber auch bei einem anderen Wert liegen.

Im Koordinatensystem darunter, im vierten Koordinatensystem der Figur 2, sind auf der Achse der Ausprägung des digitalen Signals 20c gegen die Zeitachse am Empfänger 21b das aus den Abtastwerten und der Entscheidungsschwelle gewonnene digitale Signal 27a ("eins), 27b ("null") dargestellt. Zu erkennen ist, dass das digitale Signal von einer logischen eins 27a einer zu einer logischen null 27b abrupt abfällt.

Die Zeitspanne zwischen dem Zeitpunkt, an dem das Signal am Sender 22 die mittlere Amplitude 26a schneidet und dem Zeitpunkt, an dem das digitale Signal seinen Zustand von eins 27a auf null 27b ändert, ist als Doppelpfeil 30b veranschaulicht.

Es ist zu erkennen, dass sich abhängig von der Lage und der Abtastungen der Abtastwerte 25 des Signals 22a unterschiedliche Abweichungen zwischen den Doppelpfeil 30a und 30b ergeben, die die Genauigkeit der Laufzeitmessung begrenzen.

Im fünften Koordinatensystem der Figur 2, dass erneut die Zeitachse am Empfänger 21b und die Amplitudenachse am Empfänger 20b zeigt sind erneut die Abtastwerte 25 wie im dritten Koordinatensystem der Figur 2 gezeigt. Veranschaulicht ist hier aber wie erfindungsgemäß aus einem Abtastwert 31 eine genauere Laufzeitmessung generiert werden kann: Unter Kenntnis des Signalverlaufs 22 am Sender kann der Zeitpunkt 29b ermittelt werden, an dem im Signal 22 dieser Wert des Abtastwertes gegeben war. Dies ist durch den punktierten Pfeil zwischen fünftem und erstem Koordinatensystem veranschaulicht.

Die Zeitspanne zwischen dem Zeitpunkt 29b, zu dem der Wert der Abtastung im Signal 22 gegeben war, und dem Zeitpunkt der Abtastung des Abtastwertes 31, veranschaulicht durch Doppelpfeil 30c, stellt eine sehr genaue Messung der Signallaufzeit zwischen Sender und Empfänger dar.

Diese Analyse kann für alle Abtastwerte in der Flanke, die also zwischen dem ersten und dem zweiten Wert liegen, also insbesondere in diesem Beispiel für den Abtastwert vor dem Abtastwert 31 und für den Abtastwert nach dem Abtastwert 31 wiederholt werden. Dadurch lässt sich, beispielsweise durch Mittelung der Ergebnisse, eine deutliche Erhöhung der Genauigkeit erreichen.

Eine weitere Steigerung der Genauigkeit kann durch eine Abflachung der Flanke, wie im punktierten Signal 23 im ersten Koordinatensystem angedeutet, erreicht werden, aber auch durch eine Erhöhung der Abtastrate und der Auflösung der Abtastwerte (Bittiefe), aber auch durch Durchführung des Verfahrens an einer Mehr- oder Vielzahl von Flanken des Signals kann eine weitere Erhöhung der Genauigkeit erreicht werden. Das Prinzip lässt sich einfach auf eine Flanke der Phase und/oder Frequenz übertragen.

### Bezugszeichenliste

- 1: Antenne
- 2: Sendeverstärker
- 3: Eingangsverstärker
- 4: Mischer
- 5: Bandpassfilter
- 6: Analog-Digital-Wandler
- 7: Demodulator
- 8: Fehlerkorrektur und Codierer und Decodierer
- 9: Pakethandler
- 10: Eingangs FiFo Speicher
- 11: Schnittstellentreiber
- 12: Eingang
- 13: Phasenschieber
- 14: Frequenzsynthesizer
- 15: Modulator
- 16: Ausgangs FiFo Speicher
- 20: Amplitudenachse Sender
- 20a: Amplitudenachse Empfänger
- 20b: Abtastwertachse Empfänger
- 20c: Achse des digitalen Signals
- 21a: Zeitachse am Sender
- 21b: Zeitachse am Empfänger
- 22: analoges Signal
- 22a: analoges Signal
- 23: analoges Signal
- 24: Zeitpunkt der mittleren Amplitude am Sender
- 24b: Zeitpunkt der mittleren Amplitude am Empfänger
- 24c: Zeitpunkt des die Entscheidungsschwelle unterschreitenden Messwerts
- 25: Messwert
- 26a: mittlere Amplitude
- 26b: Entscheidungsschwelle
- 27a: digitales Signal "1"
- 27b: digitales Signal "0"
- 28: Amplitude eines Messwertes in der Flanke
- 29a: Messzeit der Amplitude am Empfänger
- 29b: Zeit der gemessenen Amplitude am Sender
- 30a: Zeitspanne zwischen Senden und Empfang
- 30b: Zeitspanne zwischen Senden und Zeitpunkt des die Entscheidungsschwelle unterschreitenden Messwerts
- 30c: gemessene Zeitspanne
- 31: Abtastung auf Flanke
- 32: Flanke

## Patentansprüche

1. Verfahren zur Analyse der zeitlichen Lage und/oder Phasenlage, insbesondere zur Laufzeitmessung, Phasenmessung und/oder Synchronisierung, in einem Übertragungssystem, wobei mittels des Übertragungssystems mindestens eine erste, insbesondere digitale, Information in mindestens einem ersten analogen Signal codiert von einem ersten zu einem zweiten Objekt, übertragen wird,
**dadurch gekennzeichnet, dass** mindestens ein erster Abtastwert (31) des mindestens einen ersten analogen Signals (22a) am zweiten Objekt, verwendet wird, um eine zeitlichen Lage und/oder Phasenlage dadurch zu bestimmen, dass aus dem mindestens einen ersten Abtastwert des mindestens einen ersten analogen Signals (22a) am zweiten Objekt, der in einer steigenden oder fallenden Flanke (32) des mindestens einen ersten analogen Signals liegt, zusammen mit Kenntnis über den Verlauf der Flanke im mindestens einen ersten analogen Signal, insbesondere am ersten und/oder zweiten Objekt, die zeitliche Lage des mindestens einen ersten Abtastwerts im mindestens einen ersten analogen Signal und dadurch die zeitliche Lage des ersten analogen Signals zu einer ersten Referenzzeit im und/oder am zweiten Objekt bestimmt oder in Abhängigkeit von der zeitlichen Lage des Signals eine Aktion durchgeführt wird, insbesondere vom zweiten Objekt ein erstes Antwortsignal abgestrahlt wird, insbesondere derart, dass zwischen der zeitlichen Lage und/oder Phasenlage des ersten analogen Signals und des ersten Antwortsignals eine vorbestimmte und/oder kommunizierte Beziehung besteht.

2. Verfahren nach Anspruch 1, wobei es sich um ein bidirektionales Datenübertragungssystem handelt und/oder wobei mittels des digitalen Übertragungssystems mindestens eine zweite Information in mindestens einem zweiten analogen Signal codiert vom zweiten zum ersten Objekt übertragen wird, wobei mindestens ein erster Abtastwert des mindestens einen zweiten analogen Signals am ersten Objekt, verwendet wird, um eine zeitlichen Lage und/oder Phasenlage dadurch zu bestimmen, dass aus dem mindestens einen ersten Abtastwert des mindestens einen zweiten analogen Signals, der in einer steigenden oder fallenden Flanke des mindestens einen zweiten analogen Signals liegt, zusammen mit Kenntnis über den Verlauf der Flanke im mindestens einen zweiten analogen Signal, insbesondere am ersten und/oder zweiten Objekt, die zeitliche Lage des mindestens einen ersten Abtastwertes im mindestens einen zweiten analogen Signal und dadurch die zeitliche Lage des zweiten analogen Signals zu einer zweiten und/oder der ersten Referenzzeit bestimmt oder in Abhängigkeit von der zeitlichen Lage des Signals eine Aktion durchgeführt wird, insbesondere vom ersten Objekt ein zweites Antwortsignal abgestrahlt wird, insbesondere derart, dass zwischen der zeitlichen Lage und/oder der Phasenlage des zweiten analogen Signals und des zweiten Antwortsignals eine vorbestimmte und/oder kommunizierte Beziehung besteht.

3. Verfahren nach Anspruch 2, wobei eine erste Signallaufzeit und/oder erste Phasenverschiebung des mindestens einen ersten analogen Signals vom ersten zum zweiten Objekt und/oder eine zweite Signallaufzeit und/oder zweite Phasenverschiebung des mindestens einen zweiten analogen Signals vom zweiten zum ersten Objekt und/oder eine Rundlaufsignallaufzeit und/oder Rundlaufphasenverschiebung des mindestens einen ersten analogen Signals und des mindestens einen zweiten analogen Signals vom ersten Objekt über das zweiten Objekt zum ersten Objekt bestimmt wird.

4. Verfahren nach Anspruch 3, wobei aus oder unter Verwendung der ersten und/oder zweiten Signallaufzeit und/oder ersten und/oder zweiten Phasenverschiebung und/oder Rundlaufsignallaufzeit und/oder Rundlaufphasenverschiebung eine Entfernung zwischen dem ersten und zweiten Objekt bestimmt wird.

5. Verfahren nach einem der vorstehenden Ansprüche, wobei der Verlauf der Flanke des ersten und/oder zweiten Signals vom ersten und zum zweiten Objekt und/oder umgekehrt kommuniziert wird, insbesondere verschlüsselt und/oder die zeitliche Lage und/oder Phasenlage des zweiten analogen Signals am ersten Objekt vom ersten und zum zweiten Objekt kommuniziert wird und/oder die zeitliche Lage und/oder Phasenlage des ersten analogen Signals am zweiten Objekt vom zweiten und zum ersten Objekt kommuniziert wird und/oder der Zeitpunkt des Abstrahlens des ersten und/oder zweiten Signals und/oder die Zeitspanne zwischen dem Empfang und/oder Sampling des ersten Signals am zweiten Objekt und/oder des zweiten Signals am ersten Objekt vom ersten zum zweiten Objekt und/oder vom zweiten zum ersten Objekt kommuniziert wird und/oder diesem bekannt ist.

6. Verfahren nach einem der vorstehenden Ansprüche, wobei die Auflösung des mindestens einen ersten und/oder zweiten Abtastwerts und/oder des mindestens Abtastwerts des ersten Signals und/oder zweiten Signals 12 Bit oder mehr beträgt.

7. Verfahren nach einem der vorstehenden Ansprüche, wobei die erste und/oder zweite Abtastrate mindestens das 1,8-fache, insbesondere mindestens zweifache, der Symbolrate des ersten und/oder zweiten analogen Signals beträgt.

8. Verfahren nach einem der vorstehenden Ansprüche, wobei die erste und/oder zweite Abtastrate mindestens das 1,8-fache, insbesondere mindestens zweifache, der Chiprate des ersten und/oder zweiten analogen Signals beträgt.

9. Verfahren nach einem der vorstehenden Ansprüche, wobei mehrere erste Abtastungen des ersten und/oder zweiten analogen Signals durchgeführt und verwendet werden und/oder der Verlauf der Flanke des ersten und/oder zweiten analogen Signals, Auflösung und/oder Bittiefe der ersten Abtastung des ersten und/oder zweiten analogen Signals so gewählt sind, dass über den Verlauf der Flanke des ersten und/oder zweiten Slgnalsmindestens zwei, insbesondere mindestens drei Abtastungen durchgeführt werden, die insbesondere unterschiedliche Abtastwerte aufweisen.

10. Verfahren nach einem der vorstehenden Ansprüche, wobei das Verfahren mindestens n-fach unter Verwendung von mindestens n unterschiedlichen Kombinationen erster Objekte und zweiter Objekte wiederholt wird, wobei an jeder der n Kombinationen als erstes oder zweites Objekt ein an allen Kombinationen beteiligtes einheitliches und/oder dediziertes Objekt beteiligt ist und das andere aus erstem und zweitem Objekt der Kombinationen so aus einer Menge von n Objekten gewählt ist, dass jedes der n Objekte, mindestens in einer der mindestens n Wiederholung des Verfahrens und/oder n Kombinationen ein erste oder zweites Objekt darstellt.

11. Verfahren nach dem vorstehenden Anspruch, wobei bei allen mindestens n Wiederholungen das Verfahren nach einem der Ansprüche 1 bis 10 zusätzlich zwischen dem jeweiligen ersten Objekt der jeweiligen Wiederholung und dem für alle Wiederholungen einheitlichen und/oder dedizierten zweiten Objekt durchgeführt wird und insbesondere die bestimmten zeitliche Lagen des ersten analogen Signals zu einer Referenzzeit im und/oder an einem für alle Wiederholungen einheitlichen und/oder dedizierten zweiten Objekt und/oder an einem gemeinsamen Ort bereitgestellt und insbesondere verarbeitet werden und insbesonder der eine gemeinsame Ort das für alle Wiederholungen einheitliche und/oder dedizierte zweite Objekt ist.

12. Verfahren zur Sicherung eines Zugangssystem aufweisend ein Autorisierungsmittel und ein Zugangskontrollmittel, wobei zwischen dem Autorisierungsmittel und dem Zugangskontrollmittel elektrisch, magnetisch oder elektromagnetisch Signale übertragen werden, wobei die Signallaufzeit, Signalrundlaufzeit und/oder Entfernung zwischen Autorisierungsmittel und ein Zugangskontrollmittel mittels einem der vorstehenden Verfahren bestimmt wird und bei Überschreiten einer vorbestimmten Signallaufzeit und/oder Signalrundlaufzeit und/oder einer vorbestimmten Entfernung und/oder bei Überschreiten einer vorbestimmten Abweichung von auf anderem Weg oder mittels anderem Verfahren bestimmter Signallaufzeit und/oder Signalrundlaufzeit und/oder Entfernung der Zugang, Zutritt und/oder ein Öffnen durch das Zugangskontrollmittel verwehrt wird.

13. Übertragungssystem mit Mitteln zur Analyse der zeitlichen Lage und/oder Phasenlage, insbesondere zur Laufzeitmessung, Phasenmessung oder Synchronisierung, wobei das Übertragungssystem mindestens zwei Objekte aufweist und eingerichtet ist, mindestens eine erste Information in mindestens einem ersten analogen Signal codiert zwischen den zwei Objekten zu übertragen,
**dadurch gekennzeichnet, dass** das System eingerichtet ist, mindestens einen ersten Abtastwert des mindestens einen ersten analogen Signals nach der Übertragung zwischen den zwei Objekten in einer steigenden oder fallenden Flanke des mindestens einen ersten analogen Signals zu nehmen und diesen zu verwenden, um eine zeitlichen Lage und/oder Phasenlage dadurch zu bestimmen, dass aus dem mindestens einen ersten Abtastwert zusammen mit Kenntnis über den Verlauf der Flanke im mindestens einen ersten analogen Signal, insbesondere am ersten und/oder zweiten Objekt, die zeitliche Lage des mindestens einen ersten Abtastwertes im mindestens einen ersten analogen Signal und dadurch die zeitliche Lage des ersten analogen Signals zu einer Referenzzeit im zweiten Objekt zu bestimmen oder in Abhängigkeit von der zeitlichen Lage des Signals eine Aktion durchzuführen, insbesondere vom zweiten Objekt ein erstes Antwortsignal abzustrahlen, insbesondere derart, dass zwischen der zeitlichen Lage des ersten analogen Signals und des ersten Antwortsignals eine vorbestimmte und/oder im Übertragungssystem kommunizierte Beziehung besteht.

14. Verwendung mindestens eines ersten Abtastwertes mindestens eines ersten analogen Signals und insbesondere erhalten mittels mindestens eines ersten Analog-Digital-Wandlers, zum zeitlich aufgelösten Erfassen der Lage des mindestens einen ersten Signals relativ zu einer Referenzzeit und/oder zum Auslösen und/oder Durchführen einer Aktion in Abhängigkeit von der zeitlichen Lage des Signals, **dadurch gekennzeichnet, dass** der mindestens eine erste Abtastwert des mindestens einen ersten analogen Signals in einer steigenden oder fallenden Flanke des mindestens einen ersten analogen Signals liegt, und Kenntnis über den Verlauf der Flanke im mindestens einen ersten analogen Signal verwendet wird, um die zeitliche Lage des mindestens einen ersten Abtastwertes im mindestens einen ersten analogen Signal und dadurch die zeitliche Lage des ersten analogen Signals zu einer Referenzzeit zu bestimmen und/oder in Abhängigkeit von der zeitlichen Lage des Signals die Aktion durchzuführen und/oder auszulösen, insbesondere ein erstes Antwortsignal abzustrahlen, insbesondere derart, dass zwischen der zeitlichen Lage und/oder Phasenlage des ersten analogen Signals (22) und des erstes Antwortsignals eine vorbestimmte und/oder kommunizierte zeitliche Beziehung besteht.

15. Verwendung nach dem vorstehenden Anspruch, wobei das erste analoge Signal an einem ersten Objekt erzeugt und von diesem mittels elektromagnetischer, elektrischer oder magnetischer Signale an ein zweites Objekt übertragen wird und der Abtastwert an dem zweiten Objekt ermittelt wird und die erste Referenzzeit eine Zeit am zweiten Objekt ist und und/oder das Auslösen und/oder Durchführen der Aktion am zweiten Objekt erfolgt und insbesondere das erste Antwortsignal vom zweiten Objekt abgestrahlt wird und die zeitliche Beziehung zwischen der zeitlichen Lage des ersten analogen Signals am zweiten Objekt und des erstes Antwortsignals am zweiten Objekt gegeben ist.
